# EUROPEAN PATENT SPECIFICATION

(11) **EP 0 720 024 B1**
(45) Date of publication and mention of the grant of the patent: **14.11.2001**
(21) Application number: 95309196.4
(22) Date of filing: 18.12.1995
(51) Int. Cl.: G01R 33/3815

(54) **Helium recondensing superconducting magnet**
Supraleitender Magnet mit Helium-Rekondensierung
Aimant supraconducteur à recondensation d'hélium

(30) Priority: 29.12.1994 US 366187
(43) Date of publication of application: 03.07.1996
(73) Proprietor: GENERAL ELECTRIC COMPANY, Schenectady, NY 12345 (US)
(72) Inventor: Ito, Katsuhiko, Tokyo (JP); Kanazawa, Yoshiaki, Fujisawa City, Kanagawa (JP); Chen, William E-Wei, Florence, South Carolina 29505 (US)
(74) Representative: Goode, Ian Roy

(56) References cited:
- EP-A- 0 414 443
- DE-A- 4 019 816
- US-A- 4 891 951

## Description

### BACKGROUND OF INVENTION

This invention relates to helium cooled superconducting magnet assemblies suitable for magnetic resonance imaging (hereinafter called "MRI"), and more particularly to an improved and simplified means for recondensing the resultant helium gas back into liquid helium.

As is well known, a superconducting magnet can be made superconducting by placing it in an extremely cold environment, such as by enclosing it in a cryostat or pressure vessel containing liquid helium or other cryogen. The extreme cold insures that the magnet coils are maintained in superconducting operation, such that when a power source is initially connected to the coil (for a period, for example, of 10 minutes) to introduce a current flow through the coils, the current will continue to flow through the coils even after power is removed due to the absence of electrical resistance in the coils, thereby maintaining a strong magnetic field. Superconducting magnet assemblies find wide application in the field of MRI.

One such assembly is shown in EP-A-0414443.

Considerable research and development efforts have been directed at minimizing the need to replenish the boiling cryogen such as liquid helium. While the use of liquid helium to provide cryogenic temperatures is widely practiced and is satisfactory for MRI operation. The provision of a steady supply of liquid helium to MRI installations all over the world has proved to be difficult and costly.

As a result, it is highly desirable to minimize the amount of liquid helium required and to minimize or eliminate the need to continually replenish the liquid helium supply as the liquid helium boils in providing the superconducting temperature for the superconducting magnet assembly. It is common practice to vent the helium gas from the boiling helium and to periodically replenish the helium supply.

Another problem encountered in the use of liquid helium to provide cryogenic temperatures for superconducting magnet assemblies is encountered in storing the necessary reserve supply of liquid helium at cryogenic temperatures of 4° K (or close to absolute zero) and the related problems of periodically transferring a portion of the liquid helium in the storage reservoir to the liquid helium supply in the superconducting magnet.

Various attempts have been made to recycle the helium off-gas resulting from the boiling helium. They have not been entirely satisfactory. One difficulty encountered in the efforts to recondense helium gas has been that of access to, and servicing of, the recondensing equipment. It is extremely important that the MRI be maintained in operating condition during any servicing of the recondensing equipment or apparatus since any discontinuance of superconducting operation results in a boiloff of the helium supply in the superconducting magnet assembly, and provides considerable down time during the servicing of the recondensing equipment and the subsequent ramping up and shimming of the superconducting magnet to homogeneous superconducting operation. Such procedures are necessarily costly in time and material, not the least of which is the expense associated with the inability to utilize the expensive MRI equipment during the down time period.

The lack of thermal isolation between the cryocooler and the cold helium gas in the helium vessel has resulted in increased service time, higher cryogen consumption during service, and contamination of the recondensing contact surfaces and/or the cryocooler system. Accordingly, it is important to be able to avoid contamination and to provide recondensing equipment which can be removed and serviced while maintaining superconducting operation of the superconducting magnet assembly.

### OBJECTS AND SUMMARY OF INVENTION

The present invention seeks to provide an improved helium recondensing superconducting magnet assembly.

The present invention also seeks to provide an improved recondensing helium cooled superconducting magnet assembly utilizing a cryocooler which can be removed and serviced without discontinuing superconducting magnet MRI system operation.

The present invention further seeks to provide an improved recondensing helium cooled superconducting magnet assembly which utilizes a cryocooler thermally isolated and outside of the helium vessel and which minimizes the amount of liquid helium consumption and the vibration transmitted from the cryocooler. Due to the thermal isolation, it is a still further object to provide a clean contact surface between the cryocooler and the magnet sleeve after service to ensure good thermal performance.

According to the invention, there is provided a helium cooled superconducting magnet assembly suitable for magnetic resonance imaging including helium gas recondensing apparatus comprising a helium vessel to contain a liquid helium reservoir to provide cryogenic temperatures to said magnetic resonance imaging magnet assembly for superconducting operation; a vacuum vessel surrounding said helium vessel and spaced from said helium vessel; a cryocooler sleeve comprising a sealed chamber extending from the outside of the vacuum vessel into an interior region between said helium vessel and said vacuum vessel; and a cryocooler in said cryocooler sleeve; said cryocooler sleeve having a portion openable to the outside of said vacuum vessel for insertion and removal of said cryocooler into said cryocooler sleeve; characterised in that the assembly comprises a recondensing chamber in said region between said helium vessel and said vacuum vessel thermally connected to said cryocooler sleeve and being sufficiently cold to recondense said helium gas to liquid;
a first passage between said helium vessel and said recondensing chamber to conduct helium gas resulting from the boiling of said liquid helium; and
a second passage between said helium vessel and said recondensing chamber to return recondensed liquid helium to said helium vessel.

In one form of the invention, a two stage cryocooler extends into the space between the helium vessel and the surrounding vacuum vessel with its cold end or second stage thermally connected to a recondensing chamber. A first passageway is provided between the helium vessel and the recondensing chamber to conduct helium gas resulting from the boiling of the liquid helium during superconducting magnet operation, and a second passage connects between the bottom of the recondensing chamber and the helium vessel to return recondensed liquid helium to the helium vessel. The recondensing chamber is sufficiently cold to recondense the helium gas to liquid helium.

More particularly, the first stage of the cryocooler is thermally connected to a radiation shield interposed between the helium vessel and the vacuum vessel with flexible coupling extending between the first stage of the cryocooler and the radiation shield. The recondensing chamber includes a plurality of recondensing surfaces which are thermally connected to the second stage of the cryocooler in order to recondense impinging helium gas back to liquid helium. The first passage connects between the upper portion of the helium vessel and the recondensing chamber, while the second passage connects between the lower portion of the recondensing chamber and a lower level of the helium vessel such that the recondensed liquid helium flows back to the helium vessel by gravity. The cryocooler extends within a sleeve in the magnet assembly to enable its removal for servicing while the magnet assembly remains in superconducting operation.

### DESCRIPTION OF DRAWINGS AND INVENTION

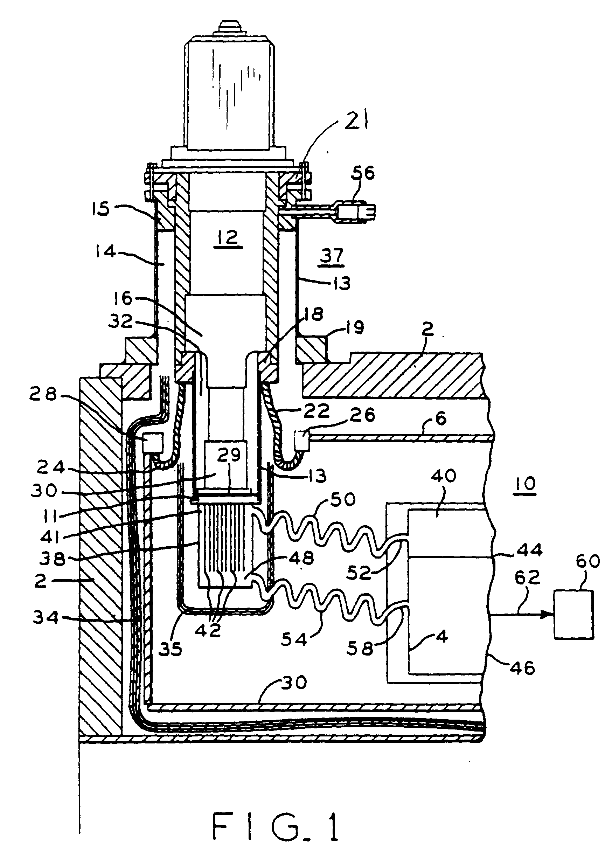

The invention will now be described in greater detail, by way of example, with reference to the drawing, the single figure of which is a cross-section, of an MRI superconducting magnet incorporating the present Invention.

Referring to the drawing, MRI magnet system 10 Includes a helium vessel 4 surrounded by a vacuum vessel 2 with an intervening thermally isolating radiation shield 6 interposed. between the helium vessel and the vacuum vessel. A cryocooler 12 (which may be a Gifford-Mahon cryocooler) extends through vacuum vessel 2 within sleeve 13 such that the cryocooler may be selectively positioned within the sleeve without destroying the vacuum within vacuum vessel 2. External cryocooler sleeve ring 14 extends outside vacuum vessel 2 and collar 19 and sleeve flange 15 enables the securing of cryocooler sleeve 13 to vacuum vessel 2. Cryocooler 12 is installed in the cyrocooler sleeve with a matching transition flange 21 and secured with bolts and washers.

First stage heat station 16 of cryocooler 12 contacts copper 1st stage thermal sleeve or heat sink 18 which is thermally connected through braided copper flexible thermal couplings 22 and 24 to isolating radiation shield 6 through connection to copper thermal blocks 26 on radiation shield 6 to cool the radiation shield to a temperature of approximately 60°K and provide thermal isolation between helium vessel 4 and vacuum vessel 2. Flexible couplings 22 and 24 provide mechanical or vibration isolation between cryocooler 12 and radiation shields.

Copper 2nd stage heat sink 11 at the bottom of cryocooler sleeve 13 and the bottom surface of second stage heat station 30 of cryocooler 12 establish contacts withthin indium gasket 29 to efficiently provide a temperature of 4K to heat sink 11.

Extending below, and thermally connected to, heat sink 11 is helium recondensing chamber 38 which includes a plurality of substantially parallel heat transfer plates or surfaces 42 in thermal contact with heat sink 11 and forming passages between the surfaces of the plates for the passage of helium gas from helium vessel 4.

Helium gas 40 which forms above liquid helium surface level 44 of liquid helium supply 46 through the boiling of the liquid helium in providing cryogenic temperatures to MRI magnet system 10 passes through gas passageway 52 through the walls of helium vessel 4 and is conducted through helium gas passage 50 to the interior of the upper portion 41 of helium recondensing chamber 38. When heat transfer plates 42 are cooled to 4K by second stage 30 of cryocooler 12, helium gas 40 will recondense into liquid helium and collect in the bottom 48 of helium recondensing chamber 38. The recondensed liquid helium flows through helium return line 54 by gravity through liquid helium passage 58 and helium vessel 4 back to liquid helium supply 46, it being noted that helium recondensing chamber 38 is higher than liquid helium passageway 58 in helium vessel 4.

As a result, during operation of MRI magnet system 10 liquid helium 46 cools superconducting magnet coil assembly shown generally as 60 with the cooling indicated generally as arrow 62 in the manner well known in the MRI art, resulting in boiling of helium liquid 46 and production of helium gas 40. However, helium gas 40 instead of being vented to the atmosphere as is common in many MRI equipments, flows through gas passageway 52 in the upper portion of and helium vessel 4, and through helium gas passage 50 to the interior of helium recondensing chamber 38 where it passes between heat transfer plates 42 of the helium recondensing chamber. Plates 42 are maintained at a temperature of 4K by second stage 30 of cryocooler 12 such that helium gas 40 recondenses to liquid helium which drops to bottom region 48 of the helium recondensing chamber 38 where it collects and flows by gravity through helium return line 54 and liquid helium passageway 58 through helium vessel 4 to liquid helium supply 46, thus recondensing and returning the helium gas back to the liquid helium supply as liquid helium.

To further thermally isolate helium vessel 4 from vacuum vessel 2, in addition to the cooling of radiation shield 6 by first stage 16 of cryocooler 12, superinsulation 34 is provided in the space between radiation shield 6 and vacuum vessel 2. Superinsulation 35 is provided between recondensing chamber 38 and helium vessel 4 to thermally isolate the recondensing chamber 38 during service of cryocooler 12 when warming up of the whole cryocooler sleeve 13 is desirable to obtain a good thermal contact between cryocooler heat stations 16, 30 and sleeve heat sinks 18, 11. Superinsulation 34 is aluminized Mylar multi-layer insulation used in the superconducting magnet industry.

It is to be noted that cryocooler sleeve 13 provides a sealed chamber or cavity 32 extending from outside vacuum vessel 2 to the interior region between the vacuum vessel and helium vessel 4 such that cryocooler assembly 12 may be removed from cryocooler sleeve 13 while maintaining a vacuum within the vacuum vessel and without discontinuing superconducting operation of MRI magnet system 10. This enables servicing of cryocooler 12 external from MRI magnet system 10 without the necessity to discontinue superconducting operation of the MRI magnet system which would result in the boiling off of the liquid helium 46 if the MRI magnet system were opened to the atmosphere by removal of the cryocooler. Discontinuance of MRI operation results in significant equipment down time with the inability to use the equipment during the down time period, followed by a necessity to replenish liquid helium supply 46, followed by ramping up of magnet system 10 to superconducting operation, and shimming the magnet system 10 to the required field homogeneity, all of which requires considerable time and significant expense which can be avoided through use of the present invention. The present invention thus facilitates and readily enables periods of removal of cryocooler 12 for periodic and necessary maintenance.

After removing cryocooler 12, the heat sinks 11 and 18 of cryocooler sleeve 13 along with the recondensing chamber 38 may be warmed up to room temperature if necessary for cleaning the contact surfaces of the 1st and 2nd stage heat sinks 11 and 18, respectively, prior to reinstalling the cryocooler into cryocooler sleeve 13. Sleeve flange 15 secures cryocooler 12 in position providing good thermal surface contact between the cryocooler and heat sinks 1 1 and 18 of cryocooler sleeve 13 after each reinstallation of the cryocooler into the. cryocooler sleeve after servicing of the cryocooler. Subsequent operation of cryocooler 12 will cool heat transfer plates 42 to around 4K to recommence recondensation of helium gas 40, including a helium gas which has accumulated during the period of servicing of cryocooler 12.

The thermal isolation provided by the stainless steel thin wall tubing of helium gas passage 50 and helium liquid return line 54 in the vacuum space between recondensing chamber 38 and helium vessel 4 reduces the amount of helium boil off and formation of helium gas 40 during the servicing of the cryocooler, and keeps helium boil off to a minimum amount. The pleated or sinusoidal configuration of helium gas passage 50 and helium return line 54 are designed such that they also provide flexibility and vibration isolation to minimize vibration transmitted from cryocooler 12 to helium vessel 4. The recondensing chamber 38 also works as a thermal switch when warm during servicing of cryocooler 12 by blocking cold helium gas 40 from flowing into the chamber 38. Cryocooler 12 can thus be removed from cryocooler sleeve 13 as a complete system without exposing any internal component of magnet system 10 to atmosphere 37 thus reducing the risk of contaminating the cryocooler system during servicing.

## Claims

1. A helium cooled superconducting magnet assembly (10) suitable for magnetic resonance imaging including helium gas recondensing apparatus comprising:
a helium vessel (4) to contain a liquid helium reservoir to provide cryogenic temperatures to said magnetic resonance imaging magnet assembly for superconducting operation;
a vacuum vessel (2) surrounding said helium vessel (4) and spaced from said helium vessel (4);
a cryocooler sleeve (13) comprising a sealed chamber extending from the outside of the vacuum vessel (2) into an interior region between said helium vessel (4) and said vacuum vessel; and
a cryocooler (12) in said cryocooler sleeve (13);
said cryocooler sleeve (13) having a portion openable to the outside of said vacuum vessel (2) for insertion and removal of said cryocooler (12) _ into said cryocooler sleeve (13); **characterised in that** the assembly comprises
a recondensing chamber (38) in said region between said helium vessel (4) and said vacuum vessel (2) thermally connected to said cryocooler sleeve (13) and being sufficiently cold to recondense said helium gas to liquid;
a first passage (50) between said helium vessel and said recondensing chamber (38) to conduct helium gas resulting from the boiling of said liquid helium; and
a second passage (54) between said helium vessel (4) and said recondensing chamber (38) to return recondensed liquid helium to said helium vessel.

2. The assembly of claim 1 including a heat sink (11) at the bottom of said cryocooler sleeve (13) and thermally connected to said recondensing chamber (38) and positioned to directly contact the cold end of said cryocooler (12) when said cryocooler (12) is positioned in said sleeve.

3. The assembly of claim 1 or 2 including a radiation shield (6) in said region between said helium vessel (4) and said vacuum vessel (2); and said cryocooler (12) being a two stage cryocooler with the first stage thereof thermally connected to said radiation shield (6), and the second stage thereof thermally connected to said helium recondensing chamber (38).

4. The assembly of claim 3 wherein at least one flexible thermal coupling (22) extends between said first stage of said cryocooler to said radiation shield.

5. The assembly of claim 4 wherein said at least one flexible thermal coupling (22) is stranded copper cable.

6. The assembly of any preceding claim wherein said recondensing chamber (38) includes a plurality of recondensing surfaces (42) thermally connected to said cryocooler (12) when said cryocooler (12) is positioned in said cryocooler sleeve (13).

7. The assembly of any preceding claim wherein said first passage comprises a helium gas passageway (50) connecting the interior of said helium vessel (4) to the interior of said recondensing chamber (38) to conduct helium gas resulting from the boiling of said helium from said helium vessel (4) to said recondensing chamber (38) with the retum flow being a gravitational flow.

8. The assembly of claim 7 wherein the second passage (52) comprises a liquid helium return passageway connecting the bottom region of said recondensing chamber (38) to said helium vessel (4) to return recondensed liquid helium to said helium vessel.

9. The assembly of claim 8 wherein said helium gas passageway (50) and said helium return passageway (52) are pleated to provide vibration isolation between said recondensing chamber (38) and said helium vessel (38).

10. The assembly of claim 8 or 9 wherein during operation said liquid helium partially fills said helium vessel and said helium gas passage is connected to the region of said helium vessel above the surface level of said liquid helium.

11. The assembly of claim 10 wherein said liquid helium return passageway (52) is connected through said helium vessel (4) below said recondensing chamber (38).

12. The assembly of claim 3 or any one of claims 4 to 11 when appendant directly or indirectly thereto wherein thermal insulation (34, 35) is provided between said radiation shield (6) and said vacuum vessel (2) and between said recondensing chamber (38) and said helium vessel (4).

13. The assembly of claim 12 wherein said thermal insulation is aluminized mylar multi-layer superinsulation.

14. The assembly of claim 4 or any one of claims 5 to 13 when when appendant directly or indirectly thereto wherein thermal heat sinks (18, 26) are provided on said first stage of said cryocooler sleeve (13) and on said radiation shield (6) and said at least one flexible thermal coupling (22) extends between said heat sinks.

15. The assembly of claim 14 wherein the heat sink on said first stage of said cryocooler is a copper collar around said first stage.

## Patentansprüche

1. Helium-gekühlte, supraleitende Magneteinrichtung (10), die für Magnetresonanz-Bildgebung geeignet ist, mit einer Helium rekondensierenden Vorrichtung, enthaltend:
einen Heliumbehälter (4), um ein Reservoir für flüssiges Helium einzuschliessen, um für cryogene Temperaturen an der Magnetresonanz-Bildgebungs-Magneteinrichtung zu sorgen,
einen Vakuumbehälter (2), der den Heliumbehälter (4) umgibt und im Abstand von dem Heliumbehälter (4) angeordnet ist,
eine Cryokühler-Hülse (13), die eine gekapselte Kammer bildet, die sich von der Aussenseite des Vakuumbehzälters (2) in einen Innenbereich zwischen dem Heliumbehälter (4) und dem Vakuumbehälter (2) erstreckt, und
einen Cryokühler (12) in der Cryokühler-Hülse (13),
wobei die Cryokühler-Hülse (13) einen Abschnitt aufweist, der zur Aussenseite des Vakuumbehälters (2) geöffnet werden kann zum Einsetzen und Herausnehmen des Cryokühlers (12) in die Cryokühler-Hülse (13),
**dadurch gekennzeichnet, daß** die Einrichtung enthält:
eine Rekondensierkammer (38) in dem Bereich zwischen dem Heliumbehälter (4) und dem Vakuumbehälter (2), der thermisch mit der Cryokühler-Hülse (13) verbunden ist und ausreichend kalt ist, um das Heliumgas zu Flüssigkeit zu rekondensieren,
einen ersten Durchlass (50) zwischen dem Heliumbehälter und der Rekondensierkammer (38), um Heliumgas zu leiten, das aus dem Sieden des flüssigen Heliums resultiert, und
einen zweiten Durchlass (54) zwischen dem Heliumbehälter (4) und der Rekondensierkammer (38), um rekondensiertes, flüssiges Helium zum Heliumbehälter zurück zu leiten.

2. Einrichtung nach Anspruch 1, enthaltend eine Wärmesenke (11) an der Unterseite der Cryokühler-Hülse (13) und thermisch verbunden mit der Rekondensierkammer (38) und so angeordnet, daß'sie das kalte Ende des Cryokühlers (12) direkt kontaktiert, wenn der Cryokühler (12) in der Hülse angeordnet ist.

3. Einrichtung nach Anspruch 1 oder 2, enthaltend eine Strahlungsabschirmung (6) in dem Bereich zwischen dem Heliumbehälter (4) und dem Vakuumbehälter (2), und wobei der Cryokühler (12) ein zweistufiger Cryokühler ist, dessen erste Stufe thermisch mit der Strahlungsabschirmung (6) verbunden ist und dessen zweite Stufe thermisch mit der Helium rekondensierenden Kammer (38) verbunden ist.

4. Einrichtung nach Anspruch 3, wobei sich wenigstens eine flexible thermische Kopplung (22) zwischen der ersten Stufe des Cryokühlers zu der Strahlungsabschirmung erstreckt.

5. Einrichtung nach Anspruch 4, wobei die wenigstens eine flexible thermische Kopplung (22) ein Kupferlitzenkabel ist.

6. Einrichtung nach einem der vorstehenden Ansprüche, wobei die Rekondensierkammer (38) mehrere Rekondensierflächen (42) aufweist, die mit dem Cryokühler (12) verbunden sind, wenn der Cryokühler (12) in der Cryokühler-Hülse (13) angeordnet ist.

7. Einrichtung nach einem der vorstehenden Ansprüche, wobei der erste Durchlass einen Heliumkanal (50) bildet, der das Innere von dem Heliumbehälter (4) mit dem Inneren von der Rekondensierkammer (38) verbindet, um Heliumgas, das aus dem Sieden des Heliums aus dem Heliumbehälter (4) resultiert, zur Rekondensierkammer (38) zu leiten, wobei der Rückfluss ein Schwerkraftfluss ist.

8. Einrichtung nach Anspruch 7, wobei der zweite Durchlass (52) einen Rückleitkanal für flüssiges Helium bildet, der den unteren Bereich von der Rekondensierkammer (38) mit dem Heliumbehälter (4) verbindet, um rekondensiertes flüssiges Helium zum Heliumbehälter zurück zu leiten.

9. Einrichtung nach Anspruch 8, wobei der Heliumgaskanal (50) und der Heliumrückleitkanal (52) gefaltet sind, um für eine Schwingungstrennung zwischen der Rekondensierkammer (38) und dem Heliumbehälter (4) zu sorgen.

10. Einrichtung nach Anspruch 8 oder 9, wobei während des Betriebs das flüssige Helium den Heliumbehälter teilweise füllt, und der Heliumgaskanal mit dem Bereich des Heliumbehälters oberhalb des Oberflächenpegels des flüssigen Heliums verbunden ist.

11. Einrichtung nach Anspruch 10, wobei der Rückleitkanal (52) für flüssiges Helium durch den Heliumbehälter (4) unterhalb der Rekondensierkammer (38) verbunden ist.

12. Einrichtung nach Anspruch 3 oder einem der Ansprüche 4 bis 11, wenn er direkt oder indirekt daran angehängt ist, wobei eine thermische Isolation (34, 35) zwischen der Strahlungsabschirmung (6) und dem Vakuumbehälter (2) und zwischen der Rekondensierkammer (38) und dem Heliumbehälter (4) vorgesehen ist.

13. Einrichtung nach Anspruch 12, wobei die thermische Isolation aluminisierte Mylar-Vielschicht-Superisolation ist.

14. Einrichtung nach Anspruch 4 oder einem der Ansprüche 5 bis 13, wenn er direkt oder indirekt daran angehängt ist, wobei thermische Wärmesenken (18, 26) auf der ersten Stufe der Cryokühler-Hülse (13) und auf der Strahlungsabschirmung (6) vorgesehen sind, und die wenigstens eine flexible, thermische Kopplung (22) sich zwischen den Wärmesenken erstreckt.

15. Einrichtung nach Anspruch 14, wobei die Wärmesenke auf der ersten Stufe des Cryokühlers ein Kupferband um die erste Stufe herum ist.

## Revendications

1. Ensemble (10) d'aimant supraconducteur refroidi à l'hélium adapté à l'imagerie par résonance magnétique, comprenant des appareils de recondensation d'hélium gazeux comportant :
une cuve à hélium (4) destinée à contenir un réservoir d'hélium liquide pour fournir des températures cryogéniques audit ensemble d'aimant d'imagerie par résonance magnétique en vue d'un fonctionnement supraconducteur ;
une cuve à vide (2) entourant ladite cuve à hélium (4) et espacée par rapport à ladite cuve à hélium (4);
un manchon de cryorefroidissement (13) comportant une chambre étanche s'étendant depuis l'extérieur de la cuve à vide (2) jusque dans une région intérieure située entre ladite cuve à hélium (4) et ladite cuve à vide ; et
un dispositif de cryorefroidissement (12) prévu dans ledit manchon de cryorefroidissement (13) ;
ledit manchon de cryorefroidissement (13) comportant une partie apte à s'ouvrir vers l'extérieur de ladite cuve à vide (2) pour permettre l'introduction dudit dispositif de cryorefroidissement (12) dans ledit manchon de cryorefroidissement (13) et son retrait de celui-ci ; **caractérisé en ce que** l'ensemble comporte :
une chambre de recondensation (38) dans ladite région située entre ladite cuve à hélium (4) et ladite cuve à vide (2), reliée thermiquement audit manchon de cryorefroidissement (13) et étant suffisamment froide pour assurer la recondensation dudit hélium gazeux en liquide ;
un premier passage (50) prévu entre ladite cuve à hélium et ladite chambre de recondensation (38) pour acheminer de l'hélium gazeux résultant de l'ébullition dudit hélium liquide ; et
un second passage (54) prévu entre ladite cuve à hélium (4) et ladite chambre de recondensation (38) pour renvoyer de l'hélium liquide recondensé à ladite cuve à hélium.

2. Ensemble selon la revendication 1, comprenant un dissipateur de chaleur (11) prévu au fond dudit manchon de cryorefroidissement (13) et relié thermiquement à ladite chambre de recondensation (38) et positionné de manière à être directement en contact avec l'extrémité froide dudit dispositif de cryorefroidissement (12) lorsque ledit dispositif de cryorefroidissement (12) est positionné dans ledit manchon.

3. Ensemble selon la revendication 1 ou 2 comprenant un écran (6) de protection contre les radiations prévu dans la région située entre ladite cuve à hélium (4) et ladite cuve à vide (2); et ledit dispositif de cryorefroidissement (12) étant un dispositif de cryorefroidissement à deux étages, le premier étage de celui-ci étant relié thermiquement audit écran (6) de protection contre les radiations, et le second étage de celui-ci étant relié thermiquement à ladite chambre (38) de recondensation d'hélium.

4. Ensemble selon la revendication 3, dans lequel au moins un moyen de couplage thermique flexible (22) s'étend entre ledit premier étage dudit dispositif de cryorefroidissement et ledit écran de protection contre les radiations.

5. Ensemble selon la revendication 4, dans lequel ledit moyen de couplage thermique flexible (22) au nombre d'au moins un est constitué d'un câble toronné en cuivre.

6. Ensemble selon l'une quelconque des revendications précédentes, dans lequel ladite chambre de recondensation (38) comprend une pluralité de surfaces de recondensation (42) reliées thermiquement audit dispositif de cryorefroidissement (12) lorsque ce dernier est positionné dans ledit manchon de cryorefroidissement (13).

7. Ensemble selon l'une quelconque des revendications précédentes, dans lequel ledit premier passage est constitué d'un conduit (50) pour hélium gazeux reliant l'intérieur de ladite cuve à hélium (4) à l'intérieur de ladite chambre de recondensation (38) pour acheminer de l'hélium gazeux résultant de l'ébullition dudit hélium de ladite cuve à hélium (4) à ladite chambre de recondensation (38), l'écoulement de retour se faisant par gravité.

8. Ensemble selon la revendication 7, dans lequel le second passage (52) est constitué d'un conduit de retour pour hélium liquide reliant la région basse de ladite chambre de recondensation (38) à ladite cuve à hélium (4) pour renvoyer de l'hélium liquide recondensé à ladite cuve à hélium.

9. Ensemble selon la revendication 8, dans lequel ledit conduit (50) pour hélium gazeux et ledit conduit (52) de retour pour hélium sont plissés pour assurer une isolation des vibrations entre ladite chambre de recondensation (38) et ladite cuve à hélium (4).

10. Ensemble selon la revendication 8 ou 9, dans lequel ledit hélium liquide remplit partiellement ladite cuve à hélium et ledit passage pour hélium gazeux est relié à la région de ladite cuve à hélium se trouvant au-dessus du niveau de la surface dudit hélium liquide.

11. Ensemble selon la revendication 10, dans lequel ledit conduit (52) de retour pour hélium liquide est relié à travers ladite cuve à hélium (4) en dessous de ladite chambre de recondensation (38).

12. Ensemble selon la revendication 3 ou l'une quelconque des revendications 4 à 11 lorsqu'elles dépendent directement ou indirectement de celle-ci, dans lequel de l'isolation thermique (34, 35) est prévue entre ledit écran (6) de protection contre les radiations et ladite cuve à vide (2) et entre ladite chambre de recondensation (38) et ladite cuve à hélium (4).

13. Ensemble selon la revendication 12, dans lequel ladite isolation thermique est une superisolation multicouches en mylar aluminisé.

14. Ensemble selon la revendication 4 ou l'une quelconque des revendications 5 à 13 lorsqu'elles dépendent directement ou indirectement de celle-ci, dans lequel des dissipateurs de chaleur (18, 26) sont prévus au niveau dudit premier étage dudit manchon de cryorefroidissement (13) et dudit écran (6) de protection contre les radiations et ledit moyen de couplage thermique flexible (22) au nombre d'au moins s'étend entre lesdits dissipateurs de chaleur.

15. Ensemble selon la revendication 14, dans lequel le dissipateur de chaleur dudit premier étage dudit dispositif de cryorefroidissement est un collier en cuivre prévu autour dudit premier étage.
